# FASCICULE DE BREVET EUROPEEN

(11) **EP 1 727 147 B1**
(45) Date de publication et mention de la délivrance du brevet: **13.07.2011**
(21) Numéro de dépôt: 06114282.4
(22) Date de dépôt: 19.05.2006
(51) Int. Cl.: G11C 7/06, G11C 11/4091

(54) **Amplificateur de lecture pour mémoire dynamique**
Leseverstärker für einen dynamischen Speicher
Sense amplifier for dynamic memory

(30) Priorité: 23.05.2005 FR 0551336
(43) Date de publication de la demande: 29.11.2006
(73) Titulaire: STMicroelectronics (Crolles 2) SAS, 38920 Crolles (FR)
(72) Inventeur: VERNET, Marc, 38100 Grenoble (FR); BOUCHE, Michel, 38000 Grenoble (FR)
(74) Mandataire: de Beaumont, Michel

(56) Documents cités:
- EP-A- 0 329 910
- US-A- 4 169 233
- US-A- 4 694 205
- US-A- 5 526 314
- US-A- 6 046 609
- US-B1- 6 201 418

## Description

### Domaine de l'invention

La présente invention concerne de façon générale les mémoires dynamiques (DRAM) et, plus particulièrement, un amplificateur de lecture de cellules d'une mémoire dynamique.

### Exposé de l'art antérieur

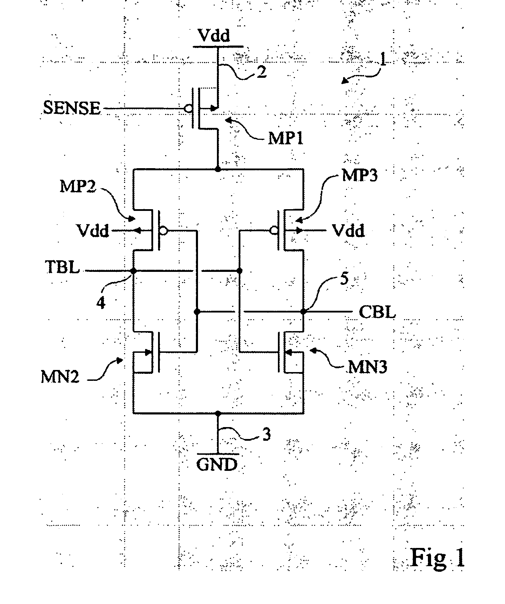

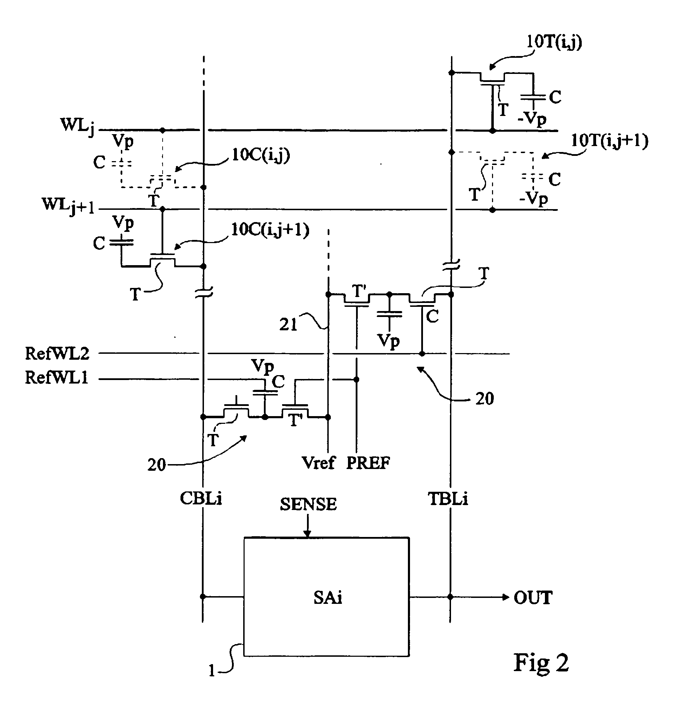

La figure 1 représente un exemple classique d'amplificateur de lecture de cellules d'une mémoire dynamique dans une configuration avec précharge à la masse. Pour simplifier la représentation de la figure, les cellules mémoires elles-mêmes n'ont pas été représentées, un exemple d'architecture mémoire du type auquel s'applique la présente invention sera décrit en relation avec la figure 2.

L'amplificateur 1 comporte, entre deux bornes 2 et 3 d'application de potentiels respectivement Vdd et GND (le cas échéant par l'intermédiaire d'un commutateur non représenté) d'alimentation, un transistor MOS à canal P MP1 et un étage d'amplification formant bascule, constitué de deux branches parallèles comportant chacune un transistor MOS à canal P MP2 respectivement MP3 et un transistor MOS à canal N respectivement MN2 et MN3. Les points milieux 4 et 5 des associations en série respectives des transistors MP2 et MN2, et des transistors MP3 et MN3, sont reliés à des lignes, dites de bit, directe TBL et complémentaire CBL de la colonne de cellules mémoires du réseau matriciel à laquelle est affecté l'amplificateur 1. Les bornes 4 et 5 définissent également des bornes de sortie respectivement directe et complémentaire de l'amplificateur de lecture 1. Les grilles des transistors MP2 et MN2 sont reliées au point 5 tandis que les grilles des transistors MP3 et MN3 sont reliées au point 4.

A chaque cycle de lecture, une seule cellule mémoire de la colonne connectée à l'amplificateur 1 est lue, celle-ci étant adressée par une sélection au moyen d'une ligne, dite de mot, au moyen d'un décodeur non représenté.

La figure 2 représente, de façon très schématique et partielle, un exemple d'architecture d'une mémoire dynamique du type auquel s'applique la présente invention. Pour simplifier, un seul amplificateur 1 (SAi) a été représenté. L'amplificateur 1 sert à lire des lignes de bit CBLi et TBLi auxquelles sont reliées des cellules mémoires 10T(i, j), 10T(i, j+1) sur la ligne TBLi et des cellules 10C(i,j) et 10C(i,j+1) sur la ligne CBLi. Chaque cellule est constituée d'un transistor de sélection T et d'un condensateur C entre la ligne de bit CBLi ou TBLi et un potentiel de polarisation Vp. Les grilles respectives des transistors T sont reliées à des lignes de mot WLj et WLj+1. En figure 2, les cellules 10C(i,j) et 10T(i,j+1) ont été représentées en pointillés pour illustrer le fait que, pour lire par exemple la cellule 10T(i,j) de ligne i et de rangée j, l'amplificateur SAi affecté aux lignes de rang i effectue la lecture sur la ligne TBLi tandis que la ligne CBLi sert de ligne de référence.

Pour lire des cellules d'une mémoire dynamique, les lignes de bit ont besoin d'être préchargées à un potentiel donné.

Une première catégorie de mémoires dynamiques prévoit une précharge des lignes de bit à la moitié Vdd/2 de la tension d'alimentation.

Une deuxième catégorie de mémoires dynamiques à laquelle s'applique plus particulièrement la présente invention prévoit une précharge des lignes de bit à la masse pour rendre la lecture plus rapide.

Dans ce cas, pour chaque ligne de bit, au moins une cellule de référence 20 est utilisée. Chaque cellule de référence 20 est typiquement constituée d'un point mémoire formé d'un transistor T et d'un condensateur C entre la ligne CBLi ou TBLi et le potentiel Vp. Les grilles des transistors T sont reliées respectivement à des lignes de sélection RefWL1 et RefWL2. De plus, les points mémoires des cellules 20 sont connectés par un transistor T' à une ligne 21 d'application d'un potentiel de référence Vref (par exemple égal à Vdd/2) en étant commandés simultanément par un signal PREF de précharge des cellules de référence.

Un exemple de mémoire dynamique utilisant des cellules de référence dans une configuration de précharge à la masse est décrit dans l'article "Embedded DRAM design and architecture for the IBM 0.11 - pm ASIC offering" de J.E. Barth, JR. et al., paru dans IBM J. RES. & DEV., vol. 46, No. 6 en novembre 2002.

Le recours à des cellules de référence dans des mémoires dynamiques accroît l'encombrement de ces mémoires (4 cellules de référence sont de plus nécessaires en cas de lignes de bit croisées - "twisted" dans l'article cité ci-dessus).

De plus, l'utilisation de cellules de référence nécessite la commande de transistors supplémentaires qui engendre une consommation non souhaitable équivalente à la lecture de quatre cellules au lieu d'une.

Un autre inconvénient est que cela allonge les cycles de lecture en raison du temps nécessaire pour équilibrer les charges des cellules de références.

Les documents US-A-5 526 314, US-A-6 046 609 et US-A-6 201 418 décrivent des amplificateurs de lecture à branches parallèles de transistors en série, dans lesquels les points milieux des associations en série ne sont pas reliés aux lignes de bits, celles-ci étant reliées aux grilles de transistors supplémentaires connectés en parallèle sur des transistors des branches.

Le document US-A-4 169 233 décrit un amplificateur de lecture CMOS dont plusieurs transistors sont en parallèle dans les branches d'un étage d'amplification différentiel.

Le document US-A-4 694 205 décrit un amplificateur de lecture à point milieu en technologie CMOS.

Le document EP 0 329 910 décrit un amplificateur de lecture a deux étages destiné à une RAM. L'un des étages comporte deux transistors recevant un même signal de commande, ces transistors étant respectivement en parallèle avec l'un des transistors de chaque branche de l'étage.

### Résumé de l'invention

La présente invention vise à pallier tout ou partie des inconvénients des mémoires dynamiques classiques et de leur lecture.

L'invention vise plus particulièrement à proposer une solution évitant le recours à des cellules de référence.

L'invention vise également à proposer une solution améliorant la sensibilité de l'amplificateur de lecture.

La présente invention est définie pour la revendication 1.

Selon un mode de réalisation de la présente invention, chaque premier transistor additionnel est en parallèle exclusivement avec le deuxième transistor du premier type de canal de la branche concernée.

Selon un mode de réalisation de la présente invention, chaque premier transistor additionnel est en série avec un deuxième transistor additionnel du même type entre une première borne d'application de la tension d'alimentation et ledit point milieu de la branche concernée.

Selon un mode de réalisation de la présente invention, un desdits premiers transistors additionnels est rendu passant avant la mise en conduction du premier transistor du premier type de canal.

L'invention prévoit également un procédé de commande d'un amplificateur de lecture d'une mémoire dynamique, consistant à rendre passant le premier transistor additionnel qui est connecté en parallèle avec la branche d'amplification opposée à celle contenant les cellules mémoires lues.

L'invention prévoit également une mémoire dynamique du type comportant un réseau matriciel de cellules connectées à des colonnes de lignes de bit directe et complémentaire et à des lignes de mot, et des amplificateurs de lecture.

Selon un mode de réalisation de la présente invention, la mémoire est dépourvue de cellule de référence préchargée à un potentiel fixe.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2 qui ont été décrites précédemment sont destinées à exposer l'état de la technique et le problème posé ;
la figure 3 représente un mode de réalisation d'un amplificateur de lecture de cellules d'une mémoire dynamique selon la présente invention ; et
les figures 4A et 4B illustrent le fonctionnement de l'amplificateur de la figure 3, respectivement pour la lecture d'un état 0 et d'un état 1.

Les mêmes éléments ont été désignés par les mêmes références aux différentes figures. Par souci de clarté, seuls les éléments qui sont nécessaires à la compréhension de l'invention ont été représentés aux figures et seront décrits par la suite. En particulier, les circuits de commande des différents éléments de la mémoire n'ont pas été détaillés, l'invention étant compatible avec les circuits classiques et notamment les décodeurs de ligne et de colonne. De plus, la génération et la synchronisation des signaux de commande de l'amplificateur de lecture n'ont pas été détaillées, l'invention étant là encore compatible avec les outils généralement utilisés pour générer de tels signaux.

### Description détaillée

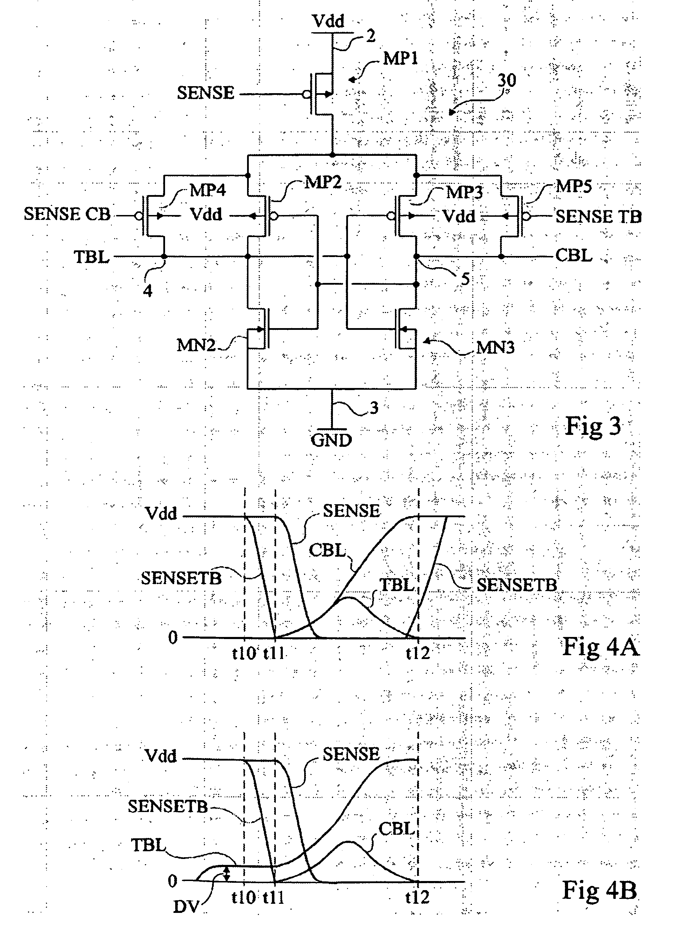

La figure 3 représente un mode de réalisation d'un amplificateur 30 de lecture de cellules d'une mémoire dynamique selon la présente invention.

Comme précédemment, un transistor MP1 à canal P de commande de l'amplificateur 30 relie une borne 2 d'application d'un potentiel Vdd à un étage formant bascule constitué de deux branches parallèles comportant chacune un transistor MOS à canal P MP2, respectivement MP3, en série avec un transistor à canal N MN2, respectivement MN3. Les sources respectives des transistors MN2 et MN3 sont connectées à une borne 3 d'application d'un potentiel de masse GND tandis que les sources respectives des transistors MP2 et MP3 sont connectées au drain du transistor MP1. Les points milieux des associations en série des transistors MP2, MN2, respectivement MP3 et MN3, définissent des bornes 4 et 5 d'entrée-sortie de l'amplificateur de lecture destinées à être reliées respectivement à une ligne de bit directe TBL et à une ligne de bit complémentaire CBL. Les grilles des transistors MP2 et MN2 sont reliées ensemble au point 5 tandis que les grilles des transistors MP3 et MN3 sont reliées ensemble au point 4 de l'autre branche. Les points 4 et 5 définissent les bornes de sortie de l'amplificateur.

Selon ce mode de réalisation de l'invention, deux transistors additionnels à canal P MP4 et MP5 sont connectés en parallèle respectivement sur les transistors MP2 et MP3. Les transistors MP4 et MP5 sont commandés par des signaux SENSE CB et SENSE TB. Les transistors MP4 et MP5 ont pour rôle de polariser dynamiquement l'amplificateur 30 lors des cycles de lecture.

L'architecture de la mémoire ressemble à celle illustrée en figure 2, mais sans cellules 20 de référence qui ne sont désormais plus nécessaires.

La figure 4A illustre le fonctionnement de l'amplificateur 30 de la figure 3 pour la lecture d'un état 0 sur la ligne TBL.

On suppose que la cellule à lire a été adressée par la ligne de mot avant un instant t10 de sorte qu'aucun signal n'a été développé sur la ligne TBL, la cellule lue étant à l'état 0. A l'instant t10, le signal SENSE TB est commuté à l'état 0 pour rendre passant le transistor MP5 (le transistor MP4 restant bloqué). A un instant t11 postérieur, le signal SENSE de l'amplificateur 30 est commuté à l'état bas pour rendre passant le transistor MP1. Le potentiel des deux lignes TBL et CBL commence à augmenter dans la mesure où les deux transistors MOS à canal P MP2 et MP3 sont à l'état passant. De plus, un courant supplémentaire circule à travers le transistor MP5, ce qui provoque un déséquilibre dans l'amplificateur à l'avantage de la ligne CBL qui croit plus vite. Cette différence de tension est amplifiée par le circuit de bascule et, à un instant t12, la ligne CBL est à l'état haut tandis que la ligne TBL est à l'état bas. Le transistor MP5 de polarisation peut être bloqué à partir de cet instant par changement d'état du signal SENSE TB.

La figure 4B illustre la lecture d'un état 1 sur la ligne TBL. Dans cette configuration, la ligne TBL n'est pas à l'état 0 mais à un état supérieur (typiquement quelques centaines de millivolts) avant l'instant t10 en raison de l'ouverture du point mémoire à lire par la commutation de la ligne de mot correspondante. A l'instant t11 où le transistor MP5 est fermé par le passage à l'état bas du signal SENSE TB, le potentiel de la ligne CBL commence à croître. Un courant supplémentaire circule dans le transistor MP5. Toutefois, en raison de l'écart initial DV entre les potentiels des lignes TBL et CBL, ce courant n'est pas suffisant pour faire basculer la ligne CBL au niveau Vdd et l'amplification réalisée conduit à une augmentation du potentiel du noeud 4 jusqu'au niveau Vdd, la ligne CBL revenant à 0.

L'écart DV entre les niveaux initiaux des lignes TBL et CBL conditionne le rapport largeur/longueur (W/L) maximal des transistors MP5 et MP4. Ce rapport ne doit pas être trop important de façon à éviter qu'à la fermeture du transistor MP1, une lecture d'un état 1 conduise à un basculement de la cellule d'amplification.

L'instant t10 où est fermé le transistor MP5 (ou MP4 si la lecture s'effectue sur la ligne CBL) n'a pas d'importance pourvu qu'il soit effectué avant la phase d'amplification (avant l'instant t11).

Les transistors MP2 et MP3 sont ceux qui doivent laisser passer, comme dans un amplificateur classique, le courant de lecture. Ils doivent de plus être rapides par rapport aux transistors MP4 et MP5 qui n'ont pas ce besoin.

Le dimensionnement des transistors MP2 et MP3 fait appel à un compromis car on les souhaite idéalement rapides (requérant un rapport largeur (W) sur longueur (L) de grille grand), petits (requérant des dimensions W et L petites) et appariés (requérant un produit W*L important).

Les transistors MP4 et MP5 n'ayant pas besoin d'être rapides, les deux autres souhaits (petits et appariés) conduisent à des critères de dimensions compatibles entre eux.

Selon une variante de réalisation, les transistors MP4 et MP5 sont chacun en série avec un deuxième transistor les reliant à la ligne 2 d'alimentation Vdd qui sont alors commandés par le signal SENSE. Ces transistors sont dans cet exemple à canal P et engendrent une légère augmentation de la surface de l'amplificateur.

Dans l'exemple représenté, les substrats (bulks) des transistors MP2, MP3, MP4 et MP5 sont portés au niveau Vdd, les substrats des transistors MN2, MN3 et MP1 étant reliés à leurs sources respectives.

Un avantage de la présente invention est qu'elle permet la suppression des cellules de référence dans les lignes des mémoires dynamiques.

Un autre avantage de l'invention est qu'il n'est désormais plus nécessaire de prévoir des générateurs de niveaux de tension pour ces références.

Un autre avantage de l'invention est qu'elle ne dégrade pas les performances de l'amplificateur tout en supprimant les cellules de référence.

Bien entendu, la présente invention est susceptible de diverses variantes et modifications qui apparaîtront à l'homme de l'art. En particulier, les dimensions respectives à donner aux différents transistors de l'amplificateur sont à la portée de l'homme du métier à partir des indications fonctionnelles données ci-dessus et de l'application.

De plus, l'adaptation des signaux de commande des différents transistors est également à la portée de l'homme du métier.

En outre, si les connexions des différents substrats (bulks des transistors) ont été précisées dans les modes de réalisation exposés, il s'agit d'exemples et ces connexions pourront être adaptées en fonction de l'application.

Enfin, bien que l'invention ait été décrite en relation avec une application où la précharge est à la masse, elle s'applique également à une précharge au niveau (Vdd) positif d'alimentation en inversant les types de transistors et avec un transistor à canal N commandé par le signal SENSE reliant l'étage différentiel d'amplification à la masse.

## Revendications

1. Amplificateur de lecture d'une mémoire dynamique comportant, en série entre deux bornes (2, 3) d'application d'une tension d'alimentation (Vdd) :
au moins un premier transistor (MP1) d'un premier type de canal ; et
un étage d'amplification d'un niveau présent sur une ligne de bits (TBL, CBL) constitué de deux branches parallèles comprenant chacune un deuxième transistor du premier type de canal (MP2, MP3) en série avec un transistor d'un deuxième type de canal (MN2, MN3), les grilles des transistors d'une même branche étant connectées au point milieu (4, 5) de l'association en série des transistors de l'autre branche, chaque point milieu définissant une borne d'entrée-sortie de l'amplificateur de lecture destinée à être reliée à une ligne de bit (TBL, CBL), chaque branche comportant au moins un premier transistor additionnel (MP4, MP5) du premier type de canal en parallèle avec au moins chaque deuxième transistor du premier type de canal;
tel que les grilles des transistors additionnels sont reliées à des bornes (SENSE CB, SENSE TB) d'application de signaux de commande différents l'un de l'autre, lesdites bornes étant distinctes des lignes de bits.

2. Amplificateur selon la revendication 1, dans lequel chaque premier transistor additionnel (MP4, MP5) est en parallèle exclusivement avec le deuxième transistor du premier type de canal (MP2, MP3) de la branche concernée.

3. Amplificateur selon la revendication 1, dans lequel chaque premier transistor additionnel (MP4, MP5) est en série avec un deuxième transistor additionnel du même type entre une première borne (2) d'application de la tension d'alimentation (Vdd) et ledit point milieu (4, 5) de la branche concernée.

4. Amplificateur selon la revendication 1, dans lequel un desdits premiers transistors additionnels (MP4, MP5) est rendu passant avant la mise en conduction du premier transistor (MP1) du premier type de canal.

5. Procédé de commande d'un amplificateur de lecture d'une mémoire dynamique selon l'une quelconque des revendications 1 à 4, consistant à rendre passant le premier transistor additionnel (MP4, MP5) qui est connecté en parallèle avec la branche d'amplification opposée à celle contenant les cellules mémoires lues.

6. Mémoire dynamique du type comportant un réseau matriciel de cellules (10) connectées à des colonnes de lignes de bit directe et complémentaire et à des lignes de mot (WL), **caractérisée en ce qu'**elle comporte des amplificateurs de lecture (30) conformes à l'une quelconque des revendications 1 à 4.

7. Mémoire dynamique selon la revendication 6, dépourvue de cellule de référence (20) préchargée à un potentiel fixe.

## Claims

1. A sense amplifier of a DRAM comprising, in series between two terminals (2, 3) of application of a power supply voltage (Vdd):
at least one first transistor (MP1) of a first channel type; and
an amplification stage of a level present on a bit line (TBL, CBL) formed of two parallel branches each comprising a second transistor of the first channel type (MP2, MP3) in series with a transistor of a second channel type (MN2, MN3), the gates of the transistors of a same branch being connected to the junction (4, 5) of the transistors of the other branch, each junction point defining a input/output terminal of the sense amplifier intended to be connected to a bit line (TBL, CBL), each branch comprising at least one first additional transistor (MP4, MP5) of the first channel type in parallel with at least each second transistor of the first channel type, such as the gates of the additional transistors are connected to terminals (SENSE CB, SENSE TB) of application of mutually different control signals, said terminals being distinct from bit lines.

2. The amplifier of claim 1, wherein each first additional transistor (MP4, MP5) is in parallel exclusively with the second transistor of the first channel type (MP2, MP3) of the involved branch.

3. The amplifier of claim 1, wherein each first additional transistor (MP4, MP5) is in series with a second additional transistor of the same type between a first terminal (2) of application of the supply voltage (Vdd) and said junction (4, 5) of the involved branch.

4. The amplifier of claim 1, wherein one of said first additional transistors (MP4, MP5) is turned on before turning-on the first transistor (MP1) of the first channel type.

5. A method for controlling the DRAM sense amplifier of any of claims 1 to 4, comprising turning-on the first additional transistor (MP4, MP5) which is connected in parallel with the amplification branch opposite to that containing the read memory cells.

6. A DRAM of the type comprising an array network (10) of cells connected to direct and complementary columns of bit lines and to word lines (WL), and comprising sense amplifiers (30) of any of claims 1 to 4.

7. The DRAM of claim 6, having no reference cell (20) precharged to a fixed voltage.

## Patentansprüche

1. Ein Leseverstärker eines DRAMs, der in Serie zwischen zwei Anschlüssen (2, 3) zum Anlegen einer Versorgungsspannung (Vdd) folgendes aufweist:
wenigstens einen ersten Transistor (MP1) eines ersten Kanaltyps; und
eine Verstärkerstufe mit einem auf einer Bit-Linie (TBL, CBL) vorhandenen Niveau, die gebildet wird aus zwei parallelen Zweigen, die jeweils einen zweiten Transistor des ersten Kanaltyps (MP2, MP3) in Serie mit einem Transistor eines zweiten Kanaltyps (MN2, MN3) aufweist, wobei die Gates der Transistoren eines gleichen Zweigs mit dem Knoten (4, 5) der Transistoren des anderen Zweigs verbunden sind, wobei jeder Knotenpunkt einen Eingangs-/Ausgangsanschluss des Leseverstärkers definiert, der mit einer Bit-Leitung (TBL, CBL) verbunden werden soll, wobei jeder Zweig wenigstens einen ersten zusätzlichen Transistor (MP4, MP5) des ersten Kanaltyps parallel zu wenigstens einem zweiten Transistor des ersten Kanaltyps aufweist, so dass die Gates der zusätzlichen Transistoren mit den Anschlüssen (SENSE CB, SENSE TB) für das Anlegen von gemeinsamen unterschiedlichen Steuersignalen verbunden sind, wobei die Anschlüsse sich von Bit-Linien unterscheiden.

2. Verstärker nach Anspruch 1, wobei jeder erste zusätzliche Transistor (MP4, MP5) ausschließlich parallel zu dem zweiten Transistor des ersten Kanaltyps (MP2, MP3) des jeweiligen Zweigs ist.

3. Verstärker nach Anspruch 1, wobei jeder erste zusätzliche Transistor (MP4, MP5) in Serie mit einem zweiten zusätzlichen Transistor desselben Typs zwischen einem ersten Anschluss (2) zum Anlegen der Versorgungsspannung (Vdd) und dem Knotenpunkt (4, 5) des jeweiligen Zweigs verbunden ist.

4. Verstärker nach Anspruch 1, wobei einer der ersten zusätzlichen Transistoren (MP4, MP5) eingeschaltet wird, bevor der erste Transistor (MP1) des ersten Kanaltyps eingeschaltet wird.

5. Verfahren zum Steuern des DRAM-Leseverstärkers nach einem der Ansprüche 1 bis 4, dass das Einschalten des ersten zusätzlichen Transistors (MP4, MP5) aufweist, der parallel zu dem Verstärkungszweig verbunden ist, und zwar entgegengesetzt zu dem der die Speicherlesezellen enthält.

6. DRAM des Typs, der Array-Netzwerk (10) aus Zellen aufweist, die mit direkten und komplementären Spalten von Bit-Linien und mit Wortlinien (WL) verbunden sind und der Leseverstärker (30) nach einem der Ansprüche 1 bis 4 aufweist.

7. DRAM nach Anspruch 6, der keine Referenzzelle (20) aufweist, die auf eine festgelegte Spannung vorgeladen ist.
